# EUROPÄISCHE PATENTSCHRIFT

(11) **EP 1 611 515 B1**
(45) Veröffentlichungstag und Bekanntmachung des Hinweises auf die Patenterteilung: **29.05.2013**
(21) Anmeldenummer: 04724980.0
(22) Anmeldetag: 01.04.2004
(51) Int. Cl.: G06F 12/14

(54) **PROGRAMMGESTEUERTE EINHEIT**
PROGRAM-CONTROLLED UNIT
UNITE COMMANDEE PAR PROGRAMME

(30) Priorität: 04.04.2003 DE 10315638
(43) Veröffentlichungstag der Anmeldung: 04.01.2006
(73) Patentinhaber: Infineon Technologies AG, 85579 Neubiberg (DE)
(72) Erfinder: BÖNING, Werner, 80639 München (DE)
(74) Vertreter: Jannig, Peter
(86) Internationale Anmeldenummer: PCT/DE2004/000705
(87) Internationale Veröffentlichungsnummer: WO 2004/090654

(56) Entgegenhaltungen:
- US-A- 5 802 583
- US-A- 6 034 889
- US-A- 6 160 734
- US-A1- 2002 184 523

## Beschreibung

Die vorliegende Erfindung betrifft eine Vorrichtung gemäß dem Oberbegriff des Patentanspruchs 1, d.h. eine programmgesteuerte Einheit mit einem wiederholt umprogrammierbaren nichtflüchtigen Speicher zum Speichern von Daten.

Eine solche programmgesteuerte Einheit ist beispielsweise ein Mikrocontroller, ein Mikroprozessor, oder ein Signalprozessor mit einem internen Flash-Speicher, einem EEPROM oder einem sonstigen wiederholt umprogrammierbaren nichtflüchtigen Speicher.

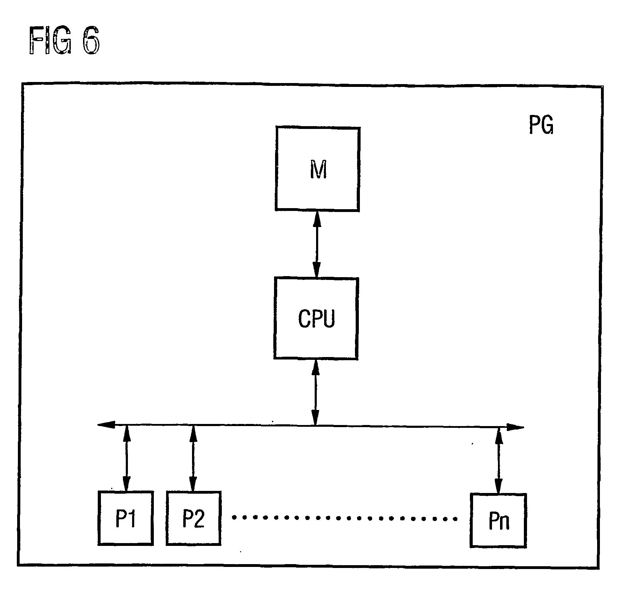

Der prinzipielle Aufbau einer solchen programmgesteuerten Einheit ist in Figur 6 gezeigt.

Die in der Figur 6 gezeigte programmgesteuerte Einheit ist mit dem Bezugszeichen PG bezeichnet. Sie enthält eine CPU CPU, eine mit der CPU verbundene Speichereinrichtung M, und über einen Bus BUS mit der CPU verbundene Peripherieeinheiten P1 bis Pn.

Die CPU führt ein Programm aus, das in der Speichereinrichtung M oder in einer in der Figur 6 nicht gezeigten anderen Speichereinrichtung gespeichert ist, wobei diese andere Speichereinrichtung eine weitere interne Speichereinrichtung oder eine außerhalb der programmgesteuerten Einheit PG vorgesehene externe Speichereinrichtung sein kann.

Die Speichereinrichtung M ist ein wiederholt umprogrammierbarer nichtflüchtiger Speicher wie beispielsweise ein Flash-Speicher und dient zur Speicherung eines Programmes und/oder der zugehörigen Operanden und/oder sonstiger Daten.

Die Peripherieeinheiten P1 bis Pn umfassen beispielsweise einen DMA-Controller, einen A/D-Wandler, einen D/A-Wandler, einen Timer, Schnittstellen und Controller zur Ein- und/oder Ausgabe von Daten, ein On-Chip-Debug-Support- bzw. OCDS-Modul, etc.

Nicht selten hat der Entwickler des von der programmgesteuerten Einheit ausgeführten Programmes ein Interesse daran, daß das Programm und/oder die Operanden durch hierzu nicht autorisierte Personen nicht verändert werden können. Manipulationen des Programmes und/oder der Operanden können nämlich dazu führen, daß die durch die programmgesteuerte Einheit gesteuerte Einrichtung nicht mehr ordnungsgemäß angesteuert und beschädigt wird.

Es sind bereits diverse Möglichkeiten bekannt, um Manipulationen von Programmen und/oder Operanden durch hierzu nicht autorisierte Personen zu verhindern. Beispielsweise kann vorgesehen werden, die zu schützenden Daten (Programme und/oder Operanden) in einem internen Speicher der programmgesteuerten Einheit wie beispielsweise der Speichereinrichtung M zu speichern, und die programmgesteuerte Einheit mit einer Speicherschutzvorrichtung auszustatten, die von dazu nicht autorisierten Personen veranlaßte Schreibzugriffe auf den internen Speicher blockiert.

Die bekannten programmgesteuerten Einheiten, bei welchen von dazu nicht autorisierten Personen veranlaßte Schreibzugriffe auf den internen Speicher blockiert werden, bieten entweder keinen perfekten Schreibschutz, und/oder sind kompliziert in der Handhabung, und/oder weisen einen komplizierten Aufbau auf und/oder weisen nur eingeschränkte Verwendungsmöglichkeiten auf.

Die Veröffentlichung US-A-6160734 offenbart eine Programmgesteuerte Einheit mit einem einmal programmierbaren nichtflüchtigen (One Time Programmable)) Speicher zum Speichern von Daten. Die offenbarte programmgesteuerte Einheit enthält einen Schutzregister, der dafür sorgt, wenn ein gewisses Bit gesetzt ist, dass der Inhalt eines bestimmten Teils des Speichers nicht mehr lesbar und schreibbar ist. In D1, kann ein Benutzer die Anzahl von geschützten Speicherblöcke in dem Schutzregister der programmgesteuerten Einheit einstellen.

Der vorliegenden Erfindung liegt daher die Aufgabe zugrunde, die programmgesteuerte Einheit derart weiterzbilden, daß dies einen

zuverlässigen Schreibschutz bietet, einen einfachen Aufbau aufweist, einfach handhabbar ist, und universell einsetzbar ist.

Diese Ausgabe wird erfindungsgemäß durch die in Patentanspruch 1 beanspruchte programmgesteuerte Einheit gelöst.

Weitere Ausführungsformen der Erfindung sind in den abhängigen Ansprüche Spezifiziert.

Die erfindüngsemäße programmgesteuerte Einheit zeichnet sich dadurch aus, daß sie eine Speicherschutzvorrichtung enthält, die in der Lage ist, dafür zu sorgen, daß der Inhalt des Speichers oder eines bestimmten Teils desselben nie mehr verändert werden kann.

Dies ermöglicht es, daß sich der zu schützende Speicher oder bestimmte Teile desselben wie ein ROM verhalten kann, welches durch nichts und niemanden umprogrammierbar ist. Somit kann der zu schützende Speicher auf einfache Weise zuverlässig vor Manipulationen durch hierzu nicht autorisierte Personen geschützt werden.

Vorteilhafte Weiterbildungen der Erfindung sind den Unteransprüchen, der folgenden Beschreibung, und den Figuren entnehmbar.

Die Erfindung wird nachfolgend anhand von Ausführungsbeispielen unter Bezugnahme auf die Figuren näher erläutert. Es zeigen
- Figur 1: den Aufbau einer vor Zugriffen durch dazu nicht autorisierte Personen schützbaren Speichereinrichtung der im folgenden beschriebenen programmgesteuerten Einheit,
- Figur 2: die Anordnung von protection configuration bits in einem ersten user configuration block der in der Figur 1 gezeigten Speichereinrichtung,
- Figur 3: die Anordnung von protection configuration bits in einem zweiten user configuration block der in der Figur 1 gezeigten Speichereinrichtung,
- Figur 4: die Anordnung von protection configuration bits in einem dritten user configuration block der in der Figur 1 gezeigten Speichereinrichtung,
- Figur 5: den Aufbau eines Konfigurationsregisters der in der Figur 1 gezeigten Speichereinrichtung, und
- Figur 6: den Aufbau einer programmgesteuerten Einheit.

Bei der im folgenden beschriebenen programmgesteuerten Einheit handelt es sich um einen Mikrocontroller. Es sei jedoch bereits an dieser Stelle darauf hingewiesen, daß es sich auch um eine beliebige andere programmgesteuerte Einheit wie beispielsweise um einen Mikroprozessor oder um einen Signalprozessor handeln könnte.

Der beschriebene Mikrocontroller hat den selben prinzipiellen Aufbau wie die in der Figur 6 gezeigte programmgesteuerte Einheit. Er enthält jedoch Schutzmechanismen, durch welche besonders einfach, flexibel und zuverlässig verhindert werden kann, daß in der Speichereinrichtung M gespeicherte Daten durch dazu nicht autorisierte Personen ausgelesen und/oder verändert werden können. Unter Daten sind sowohl Befehle repräsentierende Daten (Befehlscode) als auch keinen Befehlscode repräsentierende "normale" Daten wie Operanden, Parameter, Konstanten etc. zu verstehen.

Diese Schutzmechanismen sind im betrachteten Beispiel Bestandteil der Speichereinrichtung M.

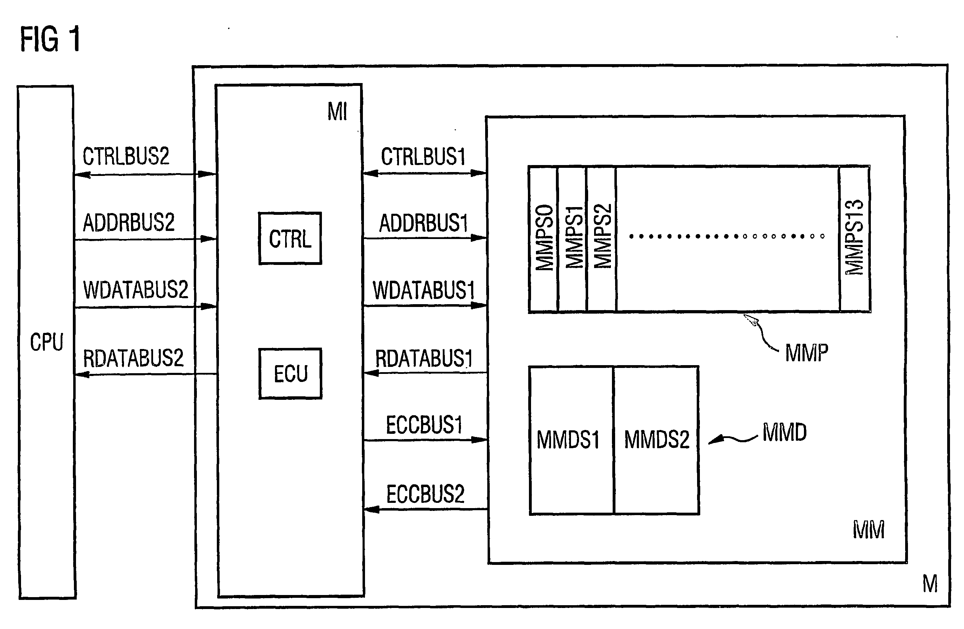

Der Aufbau der Speichereinrichtung M des hier vorgestellten Mikrocontrollers ist in Figur 1 gezeigt.

Die Speichereinrichtung M enthält ein Speichermodul MM und eine Schnittstelle MI.

Das Speichermodul MM ist der Speicher, dessen Inhalt vor einem Auslesen und/oder Verändern durch eine hierzu nicht autorisierte Person geschützt werden soll.

Der Vollständigkeit halber sei bereits an dieser Stelle angemerkt, daß dann, wenn aus dem Speichermodul MM stammende Befehle und/oder Daten in einem Cache, einen Scratchpad-Speicher oder einem sonstigen Zwischenspeicher der programmgesteuerten Einheit zwischengespeichert werden, auch deren Inhalt vor einem Auslesen durch hierzu nicht autorisierte Personen geschützt werden muß.

Das Speichermodul MM enthält im betrachteten Beispiel einen als Programmspeicher verwendeten Teil MMP, einen als Datenspeicher verwendeten Teil MMD, und weitere, in der Figur 1 nicht gezeigte Komponenten, wie insbesondere Leseverstärker, Pufferspeicher, Steuereinrichtungen etc. Der Vollständigkeit halber sei bereits an dieser Stelle darauf hingewiesen, daß das Speichermodul MM auch ein ausschließlich als Programmspeicher verwendeter Speicher, oder ein ausschließlich als Datenspeicher verwendeter Speicher sein könnte. Außerdem können auch im Programmspeicher Daten (Operanden, Konstanten etc.) gespeichert sein, und können auch im Datenspeicher Programme gespeichert sein.

Das Speichermodul MM wird im betrachteten Beispiel durch einen Flash-Speicher gebildet. Das Speichermodul MM kann aber auch ein anderer umprogrammierbarer nichtflüchtiger Speicher, beispielsweise ein EEPROM, oder ein Festspeicher wie beispielsweise ein ROM, oder ein flüchtiger Speicher wie beispielsweise ein RAM sein.

Im betrachteten Beispiel ist der Programmspeicher MMP in 14 Sektoren MMPS0 bis MMPS13 unterteilt, wobei die Sektoren MMPS1 bis MMPS13 zum Speichern von Programmen vorgesehen sind, und wobei der Sektor MMPS0 zur Speicherung von Konfigurationsdaten vorgesehen ist.

Von den zur Speicherung von Programmen vorgesehenen Sektoren MMPS1 bis MMPS13 weisen die Sektoren MMPS1 bis MMPS8 jeweils eine Speicherkapazität von 16 kByte auf, der Sektor MMPS9 eine Speicherkapazität von 128 kByte, der Sektor MMPS10 eine Speicherkapazität von 256 kByte, und die Sektoren MMPS11 bis MMPS13 jeweils eine Speicherkapazität von 512 kByte.

Die im Sektor MMPS0 gespeicherten Konfigurationsdaten dienen zur Konfigurierung des Schreibschutzes und des Leseschutzes, durch welche das Auslesen und/oder Verändern der in den Sektoren MMPS1 bis MMPS13 und im Datenspeicher MMD gespeicherten Daten durch dazu nicht autorisierte Personen verhindert wird.

Der Datenspeicher MMD weist im betrachteten Beispiel eine Speicherkapazität von 128 kByte auf und ist in 2 Sektoren MMDS1 und MMDS2 unterteilt, welche jeweils 64 kByte umfassen.

Der Vollständigkeit halber sei darauf hingewiesen, daß sowohl beim Programmspeicher MMP als auch beim Datenspeicher MMD sowohl die Anzahl der Sektoren als auch die Größe der Sektoren beliebig viel größer oder kleiner sein kann.

Das Speichermodul MM wird über die Schnittstelle MI angesprochen. D.h., sämtliche Zugriffe auf das Speichermodul MM erfolgen über die Schnittstelle MI.

Die Schnittstelle MI enthält eine Steuereinrichtung CTRL, eine Fehlerkorrektureinrichtung ECU, sowie in der Figur 1 nicht gezeigte weitere Komponenten wie Buffer, Latches, Register etc..

Die Schnittstelle MI und das Speichermodul MM sind über einen Steuerbus CTRLBUS1, einen Adreßbus ADDRBUS1, einen Schreibdatenbus WDATABUS1, einen Lesedatenbus RDATABUS1, und Fehlerkorrekturdatenbusse ECCBUS1 und ECCBUS2 miteinander verbunden.

Die Schnittstelle MI ist mit der CPU und weiteren Komponenten des Mikrocontrollers, die auf die Speichereinrichtung M zugreifen können, über einen Steuerbus CTRLBUS2, einen Adreßbus ADDRBUS2, einen Schreibdatenbus WDATABUS2, und einen Lesedatenbus RDATABUS2 verbunden.

Zu den weiteren Komponenten, die neben der CPU auf die Speichereinrichtung M zugreifen können, gehören im betrachteten Beispiel ein DMA-Controller, ein OCDS-Modul, und ein Peripheral Control Prozessor (PCP)). Es wäre jedoch auch denkbar, daß weitere und/oder andere Mikrocontroller-Komponenten auf die Speichereinrichtung M zugreifen können.

Wenn eine der Einrichtungen, die auf die Speichereinrichtung M zugreifen können, Daten aus der Speichereinrichtung, genauer gesagt aus dem Programmspeicher MMP oder aus dem Datenspeicher MMD auslesen möchte, übermittelt sie über den Steuerbus CTRLBUS2 ein Lesesignal, und über den Adreßbus ADDRBUS2 die Adresse, unter welcher die benötigten Daten gespeichert sind. Die Steuereinrichtung CTRL der Schnittstelle MI überprüft zunächst, ob es sich um einen zulässigen Zugriff handelt. Ein unzulässiger Zugriff liegt insbesondere vor, wenn ein Leseschutz wirksam ist, durch welchen das Auslesen der durch den Lesezugriff angeforderten Daten aus der Speichereinrichtung M verhindert werden soll. Wenn die Steuereinrichtung CTRL feststellt, daß es sich um einen unzulässigen Zugriff auf die Speichereinrichtung M handelt, führt sie diesen Zugriff nicht aus und signalisiert zudem der CPU und/oder sonstigen Mikrocontroller-Komponenten, daß ein unzulässiger Zugriff auf die Speichereinrichtung M erfolgt ist. Anderenfalls, d.h. wenn es sich um einen zulässigen Zugriff handelt, veranlaßt die Steuereinrichtung CTRL durch Übermittlung entsprechender Steuersignale und Adressen an das Speichermodul MM, daß die durch den Lesezugriff aus der Speichereinrichtung M angeforderten Daten aus dem Speichermodul MM ausgelesen und an die Schnittstelle MI ausgegeben werden. Die von der Steuereinrichtung CTRL an das Speichermodul MM übermittelten Steuersignale und Adressen werden über den Steuerbus CTRLBUS1 und den Adreßbus ADDRBUS1 übertragen; die vom Speichermodul MM ausgegebenen Daten werden über den Lesedatenbus RDATABUS1 übertragen.

Neben den über den Lesedatenbus RDATABUS1 übertragenen Daten gibt das Speichermodul MM auch noch diesen Daten zugeordnete Fehlerkorrektur- bzw. ECC-Daten aus. Diese Daten werden über den ECCBUS2 übertragen.

Anschließend wird durch die Fehlerkorrektureinrichtung ECU unter Auswertung der über die Busse RDATABUS1 und ECCBUS2 erhaltenen Daten überprüft, ob die über den Lesedatenbus RDATABUS1 übertragenen Daten fehlerfrei sind. Wenn die Daten nicht fehlerfrei sind und es sich um einen korrigierbaren Fehler handelt, korrigiert sie diesen. Wie Fehler unter Verwendung eines ECC (error correction code) erkannt und korrigiert werden, ist bekannt und bedarf keiner näheren Erläuterung.

Danach gibt die Schnittstelle MI die vom Speichermodul MM ausgegebenen und gegebenenfalls korrigierten Daten über den Lesedatenbus RDATABUS2 an die Einrichtung aus, von welcher der Lesezugriff stammte.

Alle anderen Zugriffe auf die Speichereinrichtung M, insbesondere auch die Zugriffe, durch welche das Löschen von in der Speichereinrichtung M gespeicherten Daten veranlaßt wird, und die Zugriffe, durch welche das Einschreiben von Daten in die Speichereinrichtung M veranlaßt wird, werden durch die Übertragung von beispielsweise auf dem JEDEC-Standard basierenden Kommandosequenzen an die Speichereinrichtung M veranlaßt oder eingeleitet. Die Übertragung einer Kommandosequenz an die Speichereinrichtung M ist letztlich nichts anderes als ein Schreibzugriff auf die Speichereinrichtung M. D.h., der Speichereinrichtung M werden über den Steuerbus CTRLBUS2 ein Schreibsignal, über den Adreßbus ADDRBUS2 eine Adresse, und über den Schreibdatenbus WDATABUS2 Daten zugeführt. Eine Kommandosecquenz kann einen oder mehrere aufeinanderfolgende Schreibzugriffe auf die Speichereinrichtung M umfassen.

Die Schnittstelle MI interpretiert Schreibzugriffe auf die Speichereinrichtung M nicht als Zugriff, durch welchen die über den Schreibdatenbus WDATABUS2 übertragenen Daten in das Speichermodul MM zu schreiben sind. Statt dessen interpretiert sie Schreibzugriffe als Kommandos. Genauer gesagt bestimmt sie anhand der über den Adreßbus ADDRBUS2 übertragenen Adressen und der über den Schreibdatenbus WDATABUS2 übertragenen Daten, welche Aktion daraufhin auszuführen ist.

Um im Speichermodul MM Daten zu löschen, wird an die Speichereinrichtung M eine Kommandosequenz übertragen, die ein Kommando "Erase Sector" repräsentiert. Diese Kommandosequenz besteht im betrachteten Beispiel 6 Schreibzyklen, von welchen 5 Zyklen reine fail-safe-Zyklen, d.h. Zyklen mit festen Adressen und Daten sind, und nur in einem Zylus (im betrachteten Beispiel der sechste Zyklus) eine variierbare Adresse und/oder variierbare Daten übertragen werden. Eine solche Kommandosequenz kann beispielsweise darin bestehen, daß
- in einem ersten Zyklus bzw. in einem ersten Schreibzugriff auf die Speichereinrichtung die Adresse 5554 und die Daten AA,
- in einem zweiten Zyklus bzw. in einem zweiten Schreibzugriff auf die Speichereinrichtung die Adresse AAA8 und die Daten 55,
- in einem dritten Zyklus bzw. in einem dritten Schreibzugriff auf die Speichereinrichtung die Adresse 5554 und die Daten 80,
- in einem vierten Zyklus bzw. in einem vierten Schreibzugriff auf die Speichereinrichtung die Adresse 5554 und die Daten AA,
- in einem fünften Zyklus bzw. in einem fünften Schreibzugriff auf die Speichereinrichtung die Adresse AAA8 und die Daten 55, und
- in einem sechsten Zyklus bzw. in einem sechsten Schreibzugriff auf die Speichereinrichtung als Adresse die Adresse des zu löschenden Sektors und die Daten 30,
an die Speichereinrichtung M übertragen werden.

Der Vollständigkeit halber sei angemerkt, daß die Adressen und Daten vorstehend im Hexadezimal-Format angegeben sind, und daß das Löschen von im Speichermodul MM gespeicherten Daten in Einheiten von Sektoren erfolgt, also daß nur immer ein ganzer Sektor gelöscht werden kann. Insbesondere wenn es sich beim Speichermodul MM nicht um einen Flash-Speicher handelt, sondern beispielsweise um ein RAM, ein ROM, ein EEPROM etc., kann das Löschen auch in anderen Einheiten erfolgen, beispielsweise pageweise, wortweise, etc.

Die Steuereinrichtung CTRL decodiert die der Speichereinrichtung M durch Schreibzugriffe zugeführte Kommandosequenz. Genauer gesagt ermittelt sie aus den ihr durch die Schreibzugriffe zugeführten Adressen und Daten die von ihr auszuführende Aktion.

Wenn der Speichereinrichtung M eine des Kommando "Erase Sector" repräsentierende Kommandosequenz zugeführt wird, erkennt sie, daß ein bestimmter Sektor im Speichermodul MM gelöscht werden soll. Sodann überprüft die Steuereinrichtung CTRL, ob es sich hierbei um einen zulässigen Zugriff auf die Speichereinrichtung M handelt. Ein unzulässiger Zugriff liegt insbesondere vor, wenn für den zu löschenden Sektor ein Schreibschutz wirksam ist. Wenn die Steuereinrichtung CTRL feststellt, daß es sich um einen unzulässigen Zugriff auf die Speichereinrichtung M handelt, führt sie diesen Zugriff nicht aus und signalisiert zudem der CPU und/oder sonstigen Mikrocontroller-Komponenten, daß ein unzulässiger Zugriff auf die Speichereinrichtung M erfolgt ist. Anderenfalls, d.h. wenn es sich um einen zulässigen Zugriff handelt, veranlaßt die Steuereinrichtung CTRL durch Übermittlung entsprechender Steuersignale und Adressen an das Speichermodul MM, daß der im "Erase Sector"-Kommando spezifizierte Sektor im Speichermodul MM gelöscht wird.

Um in das Speichermodul MM Daten zu schreiben, wird im betrachteten Beispiel an die Speichereinrichtung M zunächst eine Kommandosequenz übertragen, die ein Kommando "Enter Page Mode" repräsentiert. Diese Kommandosequenz kann beispielsweise darin bestehen, daß in einem Schreibzugriff auf die Speichereinrichtung M die Adresse 5554 und die Daten 50 an die Speichereinrichtung M übertragen werden.

Wenn der Speichereinrichtung M eine das Kommando "Enter Page Mode" repräsentierende Kommandosequenz zugeführt wird, erkennt sie, daß sie in den Page Mode wechseln muß. Im Page Mode findet ein pageweiser Zugriff auf das Speichermodul MM statt. Eine Page umfaßt im betrachteten Beispiel bei Zugriffen auf den Programmspeicher MMP 256 Bytes, und bei Zugriffen auf den Datenspeicher MMD 128 Bytes.

Der Vollständigkeit halber sei angemerkt, daß die Größen der Pages unabhängig voneinander beliebig groß sein können. Ferner sei angemerkt, daß das "Enter-Page-Mode"-Kommando und auch die im folgenden noch genauer beschriebenen weiteren Page-Kommandos nur vorgesehen werden müssen, wenn das Speichermodul MM pageweise beschrieben wird. Insbesondere wenn das Speichermodul nicht durch einen Flash-Speicher gebildet wird, kann das Beschreiben des Speichermoduls auch in größeren oder kleineren Einheiten, beispielsweise wortweise erfolgen.

Der Wechsel in den Page Mode hat noch kein Einschreiben von Daten in das Speichermodul MM zur Folge. Dies geschieht erst durch ein später noch genauer beschriebenes "Write Page"-Kommando.

Vor der Ausführung dieses Kommandos müssen jedoch erst die in das Speichermodul MM zu schreibenden Daten an die Speichereinrichtung M übertragen werden. Dies geschieht durch ein oder mehrere "Load Page"-Kommandos.

Eine ein "Load Page"-Kommando repräsentierende Kommandosequenz kann beispielsweise darin bestehen, daß in einem Schreibzugriff auf die Speichereinrichtung M die Adresse 5550 und als Daten 32 oder 64 Bits der Daten, die in das Speichermodul MM geschrieben werden sollen, an die Speichereinrichtung M übertragen werden.

Wenn der Speichereinrichtung M eine des Kommando "Load Page" repräsentierende Kommandosequenz zugeführt wird, schreibt die Steuereinrichtung CTRL die in der Kommandosequenz enthaltenen Daten in einen beispielsweise durch ein Register gebildeten Zwischenspeicher der Schnittstelle MI. Darüber hinaus erzeugt die Steuereinrichtung CTRL, genauer gesagt die Fehlerkorrektureinrichtung ECU derselben für diese Daten Fehlerkorrektur- bzw. ECC-Daten, unter Verwendung welcher sich bei einem späteren Auslesen dieser Daten aus dem Speichermodul MM in den ausgelesenen Daten enthaltene Fehler erkennen und/oder beheben lassen, und speichert diese Daten ebenfalls in einem beispielsweise durch ein Register gebildeten Zwischenspeicher.

Der Speichereinrichtung M werden nacheinander so viele "Load Page" repräsentierende Kommandosequenzen zugeführt, bis im Zwischenspeicher so viele Daten gespeichert ist, wie von einer Page umfaßt werden.

Danach wird der Speichereinrichtung M eine ein "Write Page"-Kommando repräsentierende Kommandosequenz zugeführt. Diese Kommandosequenz kann beispielsweise darin bestehen, daß
- in einem ersten Zyklus bzw. in einem ersten Schreibzugriff auf die Speichereinrichtung die Adresse 5554 und die Daten AA,
- in einem zweiten Zyklus bzw. in einem zweiten Schreibzugriff auf die Speichereinrichtung die Adresse AAA8 und die Daten 55,
- in einem dritten Zyklus bzw. in einem dritten Schreibzugriff auf die Speichereinrichtung die Adresse 5554 und die Daten A0, und
- in einem vierten Zyklus bzw. in einem vierten Schreibzugriff auf die Speichereinrichtung als Adresse die Adresse der zu beschreibenden Page innerhalb des Speichermoduls, und die Daten AA,
an die Speichereinrichtung übertragen werden.

Zumindest jetzt, d.h. nach dem Empfang eines "Write Page"-Kommandos, eventuell aber auch schon nach dem Empfang eines "Enter Page Mode"-Kommandos und/oder nach dem Empfang eines "Load Page"-Kommandos überprüft die Steuereinrichtung CTRL, ob es sich bei dem betreffenden Zugriff um einen zulässigen Zugriff auf die Speichereinrichtung M handelt. Ein unzulässiger Zugriff liegt insbesondere vor, wenn ein Schreibschutz wirksam ist, durch welchen Veränderungen des Inhalts des zu beschreibenden Speicherbereiches verhindert werden sollen. Wenn die Steuereinrichtung CTRL feststellt, daß es sich um einen unzulässigen Zugriff auf die Speichereinrichtung M handelt, führt sie diesen Zugriff nicht aus und signalisiert zudem der CPU und/oder sonstigen Mikrocontroller-Komponenten, daß ein unzulässiger Zugriff auf die Speichereinrichtung M erfolgt ist. Anderenfalls, d.h. wenn es sich um einen zulässigen Zugriff handelt, veranlaßt die Steuereinrichtung CTRL durch Übermittlung der entsprechenden Steuersignale, Adressen und Daten an das Speichermodul MM, daß die im Zwischenspeicher gespeicherten Daten an die im "Write Page"-Kommando spezifizierte Stelle innerhalb des Speichermoduls geschrieben werden.

Darüber hinaus werden die zuvor erzeugten Fehlerkorrektur- bzw. ECC-Daten von der Steuereinrichtung CTRL über den Fehlerkorrekturdatenbus ECCBUS1 zum Speichermodul MM übertragen und ebenfalls im Speichermodul MM gespeichert.

Durch die vorstehend beschriebenen Kommandos können nur die Sektoren MMPS1 bis MMPS13 des Programmspeichers MMP und die Sektoren MMDS1 und MMDS2 des Datenspeichers gelöscht und beschrieben werden. Zum Löschen und Beschreiben des Sektors MMPS0 werden zumindest teilweise andere Kommandos benötigt. Diese Kommandos werden später noch genauer beschrieben.

Durch den vorstehend bereits mehrfach erwähnten Leseschutz und Schreibschutz soll und kann verhindert werden, daß in der Speichereinrichtung M gespeicherte Daten durch dazu nicht autorisierte Personen ausgelesen und/oder verändert werden.

Ob und gegebenenfalls in welchem Umfang ein Leseschutz und/oder ein Schreibschutz wirksam ist, hängt unter anderem von durch den Benutzer des Mikrocontrollers vorgenommenen Einstellungen ab. Es sei jedoch bereits an dieser Stelle darauf hingewiesen, daß es auch noch von anderen Faktoren abhängt, ob und in welchem Umfang ein Leseschutz und/oder ein Schreibschutz wirksam ist. Hierauf wird später noch genauer eingegangen.

Die durch den Benutzer vornehmbaren Einstellungen erfolgen
- durch ein entsprechendes Beschreiben von im folgenden als UCBs bezeichneten user configuration blocks,
- durch ein temporäres Aufheben und Wiederinkraftsetzen der in den UCBs enthaltenen Einstellungen, und
- durch ein Setzen und Zurücksetzen bestimmter Bits in Steuerregistern der Speichereinrichtung M.

Die erwähnten UCBs sind Bestandteil des Sektors MMPS0 des Programmspeichers MMP, und können durch den Benutzer der programmgesteuerten Einheit nur beschrieben, aber nicht ausgelesen werden. Der Sektor MMPS0 des Programmspeichers MMP enthält in betrachteten Beispiel drei UCBs, welche im folgenden als UCB0, UCB1, und UCB2 bezeichnet werden. Jeder UCB besteht aus vier Pages (Page 0 bis Page 3), von welchen jede 256 Bytes umfaßt.

Es sei bereits an dieser Stelle darauf hingewiesen, daß auch mehr oder weniger UCBs vorgesehen sein können, und daß die Anzahl und die Größe der Pages, die die UCBs umfassen, unabhängig voneinander beliebig groß sein können.

Der UCB0 kann durch einen ersten Benutzer der programmgesteuerten Einheit beschrieben und gelöscht werden und enthält im betrachteten Beispiel
- Leseschutzeinstellungen, durch welche der erste Benutzer vorgeben kann, ob ein Leseschutz wirksam sein soll,
- Schreibschutzeinstellungen, durch welche der erste Benutzer vorgegeben kann, für welche Teile des Speichermoduls MM ein Schreibschutz wirksam sein soll,
- ein vom ersten Benutzer wählbares Kennwort, unter Verwendung dessen der erste Benutzer den durch seine Leseschutzeinstellungen definierten Leseschutz und/oder den durch seine Schreibschutzeinstellungen definierten Schreibschutz temporär aufheben kann, und
- einen vorgegebenen Confirmation Code, durch dessen Einschreiben in den UCB0 der erste Benutzer die Gültigkeit der im UCB0 gespeicherten Daten bestätigt.

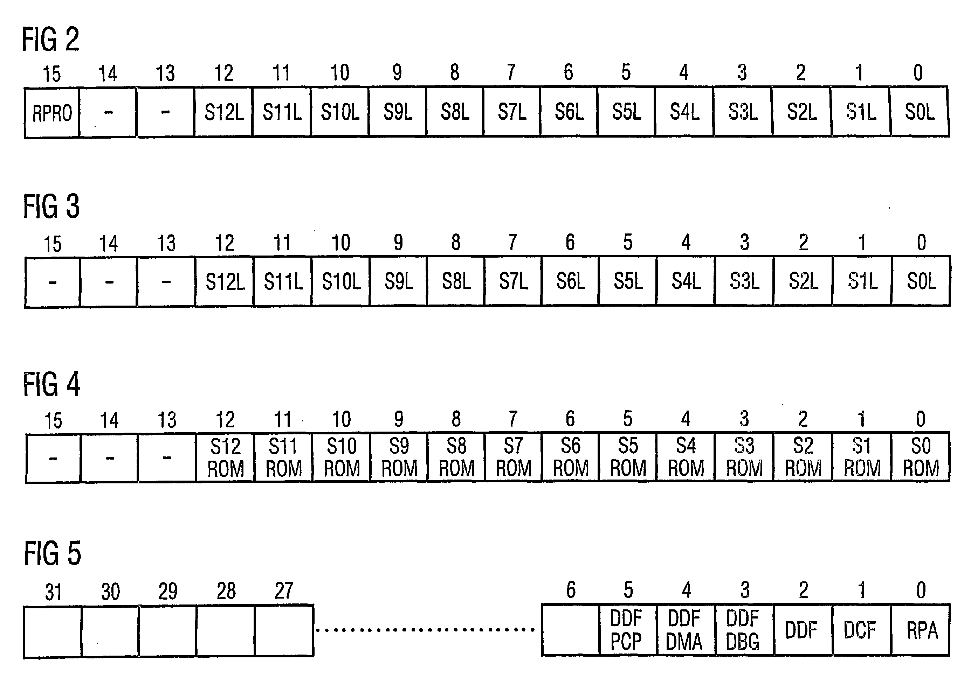

Die Leseschutzeinstellungen und die Schreibschutzeinstellungen umfassen im betrachteten Beispiel zwei Bytes. Diese Bytes werden im folgenden als Schutzeinstellungs-Bytes bezeichnet und sind in Figur 2 dargestellt.

Die Bits 0 bis 12 der Schutzeinstellungs-Bytes sind Schreibschutzeinstellungs-Bits, durch welche spezifiziert wird, für welche der Sektoren MMPS1 bis MMPS13 des Programmspeichers ein Schreibschutz wirksam sein soll; die Schreibschutzeinstellungs-Bits sind in der Figur 2 mit den Bezugszeichen S0L bis S12L bezeichnet. Von den Bits S0L bis S12L ist jeweils ein Bit einem der Sektoren MMPS1 bis MMPS13 zugeordnet. Genauer gesagt ist das Bit S0L dem Sektor MMPS1 zugeordnet, das Bit S1L dem Sektor MMPS2 zugeordnet, das Bit S2L dem Sektor MMPS3 zugeordnet,..., und das Bit S12L dem Sektor MMPS13 zugeordnet. Durch den Wert der einzelnen Bits S0L bis S12L wird festgelegt, ob für den zugeordneten Sektor ein Schreibschutz wirksam sein soll oder nicht. Wenn beispielsweise das Bit S5L den Wert 1 aufweist, bedeutet dies, daß für den zugeordneten Sektor MMPS6 ein Schreibschutz wirksam sein soll; wenn dieses Bit den Wert 0 aufweist, bedeutet dies, daß für den zugeordneten Sektor MMPS6 kein Schreibschutz wirksam sein soll.

Das Bit 15 der Schutzeinstellungs-Bytes ist ein Leseschutzeinstellungs-Bit, durch welches spezifiziert wird, ob für das Speichermodul MM ein Leseschutz wirksam sein soll; das Leseschutzeinstellungs-Bit ist in der Figur 2 mit dem Bezugszeichen RPRO bezeichnet. Wenn das Bit RPRO den Wert 1 aufweist, bedeutet dies, daß ein Leseschutz wirksam sein soll; wenn das Bit RPRO den Wert 0 aufweist, bedeutet dies, daß kein Leseschutz wirksam sein soll.

Das Kennwort umfaßt im betrachteten Beispiel 64 Bits, kann aber auch beliebig länger oder kürzer sein.

Im betrachteten Beispiel ist es so, daß die Schutzeinstellungs-Bytes und das Kennwort Bestandteil der ersten Page (Page 0) von UCB0 sind, der Confirmation Code Bestandteil der dritten Page (Page 2) von UCB0 ist, und die restlichen Pages (Pages 1 und 3) von UCB0 für zukünftige Verwendungen reserviert sind.

Der UCB1 kann durch einen zweiten Benutzer der programmgesteuerten Einheit beschrieben und gelöscht werden und enthält im betrachteten Beispiel
- Schreibschutzeinstellungen, durch welche der zweite Benutzer vorgeben kann, für welche Bereiche des Speichermoduls MM ein Schreibschutz wirksam sein soll,
- ein vom zweiten Benutzer wählbares Kennwort, unter Verwendung dessen der zweite Benutzer den durch seine Schreibschutzeinstellungen definierten Schreibschutz temporär aufheben kann, und
- einen vorgegebenen Confirmation Code, durch dessen Einschreiben der zweite Benutzer die Gültigkeit der im UCB1 gespeicherten Daten bestätigt.

Die Schreibschutzeinstellungen sind wie beim UCB0 in zwei Schutzeinstellungs-Bytes enthalten. Diese Schutzeinstellungs-Bytes sind in Figur 3 veranschaulicht.

Die Schutzeinstellungs-Bytes des UCB1 entsprechen weitestgehend den Schutzeinstellungs-Bytes des UCB0. Einziger Unterschied ist, daß in den Schutzeinstellungs-Bytes des UCB1 kein Leseschutzeinstellungs-Bit RPRO vorgesehen ist. Dies hat den Effekt, daß der zweite Benutzer nicht bestimmen kann, ob ein Leseschutz wirksam sein soll oder nicht; dies kann nur der erste Benutzer tun.

Die Schutzeinstellungs-Bytes des UCB1 enthalten aber wie die Schutzeinstellungs-Bytes des UCB0 Schreibschutzeinstellungs-Bits S0L bis S12L, über welche der zweite Benutzer einstellen kann, für welche der Sektoren MMPS1 bis MMPS13 ein Schreibschutz wirksam sein soll.

Das Kennwort umfaßt im betrachteten Beispiel 64 Bits, kann aber auch beliebig länger oder kürzer sein.

Im betrachteten Beispiel ist es so, daß die Schutzeinstellungs-Bytes und das Kennwort Bestandteil der ersten Page (Page 0) von UCB1 sind, der Confirmation Code Bestandteil der dritten Page (Page 2) von UCB1 ist, und die restlichen Pages (Pages 1 und 3) von UCB1 für zukünftige Verwendungen reserviert sind.

Der UCB2 weist gegenüber dem UCB0 und dem UCB1 einige Besonderheiten auf und wird später genauer beschrieben.

Durch Einschreiben entsprechender Daten in die Schutzeinstellungs-Bytes des UCB0 und des UCB1 kann durch den bzw. die Benutzer des Mikrocontrollers eingestellt werden, ob bzw. im welchem Umfang ein Leseschutz und/oder ein Schreibschutz wirksam sein soll.

Wenn ein Leseschutz wirksam sein soll, muß der erste Benutzer des Mikrocontrollers das Leseschutzeinstellungs-Bit RPRO der Schutzeinstellungs-Bytes des UCB0 setzen.

Im betrachteten Beispiel wird durch Setzen des Leseschutzeinstellungs-Bits RPRO des UCB0 eingestellt, daß aus dem gesamten Speichermodul MM keine Daten ausgelesen werden können sollen. Der Vollständigkeit halber sei angemerkt, daß es ohne Probleme möglich wäre, Einstellmöglichkeiten in UCB0 vorzusehen, durch welche eingestellt werden kann, daß nur für bestimmte Bereiche des Speichermoduls MM ein Leseschutz wirksam sein soll. Dies ließe sich beispielsweise dadurch bewerkstelligen, daß in den Schutzeinstellungs-Bytes von UCB0 zusätzliche Leseschutzeinstellungs-Bits vorgesehen werden und die dann vorhandenen Leseschutzeinstellungs-Bits ähnlich wie die Schreibschutzeinstellungs-Bits bestimmten Bereichen des Speichermoduls MM zugeordnet werden. Dann wäre durch die Leseschutzeinstellungs-Bits einstellbar, für welche Bereiche des Speichermoduls MM ein Leseschutz wirksam sein soll. Darüber hinaus wäre es selbstverständlich auch möglich, daß sowohl der UCB0 als auch der UCB1 ein oder mehrere Leseschutzeinstellungs-Bits enthalten. Dann könnten sowohl der erste Benutzer als auch der zweite Benutzer einstellen, ob und gegebenenfalls für welche Bereiche des Speichermoduls MM ein Leseschutz wirksam sein soll. Natürlich wäre es auch möglich, daß nur der zweite Benutzer durch entsprechende Einstellungen in UCB1 vorgeben kann, ob und gegebenenfalls in welchem Umfang ein Leseschutz wirksam sein soll.

Wenn ein Schreibschutz wirksam sein soll, müssen der erste Benutzer des Mikrocontrollers und/oder der zweite Benutzer des Mikrocontrollers eines oder mehrere der Schreibschutzeinstellungs-Bits S0L bis S12L der Schutzeinstellungs-Bytes des UCB0 bzw. des UCB1 setzen.

Im betrachteten Beispiel wird durch die Schreibschutzeinstellungs-Bits S0L bis S12L von UCB0 und UCB1 eingestellt, für welche Bereiche des Speichermoduls MM, genauer gesagt für welche Sektoren des Speichermoduls ein Schreibschutz wirksam sein soll. Ein Schreibschutz ist jeweils nur für diejenigen Sektoren wirksam, welchen die gesetzten Bits unter den Schreibschutzeinstellungs-Bits S0L bis S12L zugeordnet sind. Wenn von den Schreibschutzeinstellungs-Bits S0L bis S12L des UCB0 und des UCB1 beispielsweise nur das Schreibschutzeinstellungs-Bit S3L des UCB0 und das Schreibschutzeinstellungs-Bit S5L des UCB1 gesetzt sind, bedeutet dies, daß nur für die Sektoren MMPS4 und MMPS6 ein Schreibschutz wirksam sein soll.

Der vorstehend bereits erwähnte UCB2 kann durch einen dritten Benutzer der programmgesteuerten Einheit beschrieben werden und enthält im betrachteten Beispiel
- Schreibschutzeinstellungen, durch welche der dritte Benutzer vorgeben kann, welche Bereiche des Speichermoduls MM sich wie ein ROM verhalten sollen, und
- einen vorgegebenen Confirmation Code, durch dessen Einschreiben der dritte Benutzer die Gültigkeit der im UCB2 gespeicherten Daten bestätigt.

Die Schreibschutzeinstellungen sind wie beim UCB0 und beim UCB1 in zwei Schutzeinstellungs-Bytes enthalten. Diese schutzeinstellungs-Bytes sind in Figur 4 veranschaulicht.

Die Bits 0 bis 12 der Schutzeinstellungs-Bytes sind Schreibschutzeinstellungs-Bits, durch welche spezifiziert wird, für welche der Sektoren MMPS1 bis MMPS13 des Programmspeichers ein Schreibschutz wirksam sein soll; die Schreibschutzeinstellungs-Bits sind in der Figur 4 mit den Bezugszeichen SOROM bis S12ROM bezeichnet. Von den Bits SOROM bis S12ROM ist jeweils ein Bit einem der Sektoren MMPS1 bis MMPS13 zugeordnet. Genauer gesagt ist das Bit S0ROM dem Sektor MMPS1 zugeordnet, das Bit S1ROM dem Sektor MMPS2 zugeordnet, das Bit S2ROM dem Sektor MMPS3 zugeordnet,..., und das Bit S12ROM dem Sektor MMPS13 zugeordnet. Durch den Wert der einzelnen Bits SOROM bis S12ROM wird festgelegt, ob für den zugeordneten Sektor ein Schreibschutz wirksam sein soll oder nicht. Wenn beispielsweise das Bit S5ROM den Wert 1 aufweist, bedeutet dies, daß für den zugeordneten Sektor MMPS6 ein Schreibschutz wirksam sein soll; wenn dieses Bit den Wert 0 aufweist, bedeutet dies, daß für den zugeordneten Sektor MMPS6 kein Schreibschutz wirksam sein soll.

Insoweit entsprechen die Schutzeinstellungs-Bytes des UCB2 im wesentlichen den Schutzeinstellungs-Bytes des UCB1. Im Gegensatz zu UCB0 und UCB1 ist der UCB2 nach dem Einschreiben des Confirmation Codes jedoch nicht mehr löschbar und nicht mehr wiederbeschreibbar. Ferner kann - ebenfalls im Gegensatz zu UCB0 und UCB1 - der durch UCB2 definierte Schreibschutz nicht temporär deaktiviert werden. Dies hat den Effekt, daß durch die Schreibschutzeinstellungs-Bits des UCB2 vorgegeben wird, ob und gegebenenfalls welche Bereiche des Speichermoduls MM sich wie ein nie mehr umprogrammierbarer Speicher, also wie ein ROM verhalten. Der UCB2 verhält sich nach dem Einschreiben des Confirmation Code in diesen wie ein zumindest durch den Benutzter nicht lesbares ROM.

Im betrachteten Beispiel ist es so, daß die Schutzeinstellungs-Bytes Bestandteil der ersten Page (Page 0) von UCB2 sind, der Confirmation Code Bestandteil der dritten Page (Page 2) von UCB2 ist, und die restlichen Pages (Pages 1 und 3) von UCB2 für zukünftige Verwendungen reserviert sind.

Die UCBs können durch den ersten bzw. den zweiten bzw. den dritten Benutzer durch die Übermittlung spezieller Kommandosequenzen an die Speichereinrichtung M beschrieben werden.

Die UCBs können - ebenfalls durch die Übermittlung spezieller Kommandosequenzen - auch wieder gelöscht und erneut beschrieben werden. Sie können jedoch durch den Benutzer der programmgesteuerten Einheit nicht ausgelesen werden.

Der UCB2 kann allerdings nach dem Einschreiben des Confirmation Code in den UCB2 nicht mehr gelöscht und nicht mehr beschrieben werden.

Um einen UCB zu löschen, muß zunächst durch das vorstehend bereits erwähnte und später noch genauer beschriebene Kommando "Disable Write Protection" der Schreibschutz für den zu löschenden UCB aufgehoben werden, denn obgleich dem die UCBs enthaltenden Sektor MMPS0 kein Schreibschutzeinstellungs-Bit in den UCBs zugeordnet ist, ist jeder ordnungsgemäß, d.h. einschließlich des richtigen Confirmation Codes beschriebene UCB automatisch lese- und schreibgeschützt. Nur wenn der zu löschende UCB noch nicht oder nicht ordnungsgemäß, d.h. ohne gültigen Confirmation Code beschrieben wurde, ist keine Aufhebung des Schreibschutzes erforderlich.

Zum eigentlichen Löschen eines UCB wird an die Speichereinrichtung M eine Kommandosequenz übertragen, die ein Kommando "Erase UCB" repräsentiert. Diese Kommandosequenz kann beispielsweise darin bestehen, daß
- in einem ersten Zyklus bzw. in einem ersten Schreibzugriff auf die Speichereinrichtung die Adresse 5554 und die Daten AA,
- in einem zweiten Zyklus bzw. in einem zweiten Schreibzugriff auf die Speichereinrichtung die Adresse AAA8 und die Daten 55,
- in einem dritten Zyklus bzw. in einem dritten Schreibzugriff auf die Speichereinrichtung die Adresse 5554 und die Daten 80,
- in einem vierten Zyklus bzw. in einem vierten Schreibzugriff auf die Speichereinrichtung die Adresse 5554 und die Daten AA,
- in einem fünften Zyklus bzw. in einem fünften Schreibzugriff auf die Speichereinrichtung die Adresse AAA8 und die Daten 55, und
- in einem sechsten Zyklus bzw. in einem sechsten Schreibzugriff auf die Speichereinrichtung als Adresse die Adresse des zu löschenden UCB und die Daten 40,
an die Speichereinrichtung übertragen werden.

Wenn der Speichereinrichtung M eine das Kommando "Erase UCB" repräsentierende Kommandosequenz zugeführt wird, erkennt sie, genauer gesagt die Steuereinrichtung CTRL derselben, daß der im sechsten Zyklus der Kommandosequenz spezifizierte UCB gelöscht werden soll. Die Steuereinrichtung CTRL überprüft sodann, ob es hierbei um einen zulässigen Zugriff handelt. Ein unzulässiger Zugriff liegt insbesondere vor, wenn der zu löschende UCB schreibgeschützt ist. Wenn die Steuereinrichtung feststellt, daß ein unzulässiger Zugriff vorliegt, führt sie das Kommando nicht aus und signalisiert zudem der CPU und/oder sonstigen Mikrocontroller-Komponenten, daß ein unzulässiger Zugriff auf die Speichereinrichtung erfolgt ist. Anderenfalls, d.h. wenn es sich um einen zulässigen Zugriff handelt, veranlaßt die Steuereinrichtung CTRL durch Übermittlung entsprechender Steuersignale und Adressen an das Speichermodul MM, daß der im "Erase UCB"-Kommando spezifizierte UCB im Sektor MMPS0 des Speichermoduls MM gelöscht wird. Anders als beim eingangs beschriebenen Kommando "Erase Sector" wird durch das Kommando "Erase UCB" nicht das Löschen eines kompletten Sektors des Speichermoduls MM, sondern nur eines bestimmten UCB des Sektors MMPS0 veranlaßt.

Um in einen UCB Daten zu schreiben, wird an die Speichereinrichtung M zunächst ein "Enter Page Mode"-Kommando, dann ein oder mehrere "Load Page"-Kommandos, und schließlich ein "Write UC Page"-Kommando übertragen.

Das Beschreiben eines UCB ist nur zulässig, wenn dieser noch nie beschrieben wurde oder zuvor gelöscht wurde. Ob dies der Fall ist, wird von der Steuereinrichtung CTRL überprüft und kann beispielsweise daran erkannt werden, daß im zu beschreibenden UCB kein oder kein gültiger Confirmation Code steht.

Die das "Enter Page Mode"-Kommando und das "Load Page"-Kommando repräsentierenden Kommandosequenzen sowie die Reaktion der Steuereinrichtung CTRL auf diese Kommandos wurden bereits eingangs beschrieben.

Die das "Write UC Page"-Kommando repräsentierende Kommandosequenz kann beispielsweise darin bestehen, daß
- in einem ersten Zyklus bzw. in einem ersten Schreibzugriff auf die Speichereinrichtung die Adresse 5554 und die Daten AA,
- in einem zweiten Zyklus bzw. in einem zweiten Schreibzugriff auf die Speichereinrichtung die Adresse AAA8 und die Daten 55,
- in einem dritten Zyklus bzw. in einem dritten Schreibzugriff auf die Speichereinrichtung die Adresse 5554 und die Daten 00, und
- in einem vierten Zyklus bzw. in einem vierten Schreibzugriff auf die Speichereinrichtung als Adresse die Adresse der zu beschreibenden Page des zu beschreibenden UCB und die Daten 90,
an die Speichereinrichtung übertragen werden.

Wenn die Speichereinrichtung M ein "Write UC Page"-Kommando zugeführt bekommt, überprüft die Steuereinrichtung CTRL, ob es sich bei dem betreffenden Zugriff um einen zulässigen Zugriff auf die Speichereinrichtung M handelt. Ein unzulässiger Zugriff liegt insbesondere vor, wenn der zu beschreibende UCB bereits einen gültigen Confirmation Code enthält, also schreibgeschützt ist. Wenn die Steuereinrichtung CTRL feststellt, daß es sich um einen unzulässigen Zugriff auf die Speichereinrichtung M handelt, führt sie diesen Zugriff nicht aus und signalisiert zudem der CPU und/oder sonstigen Mikrocontroller-Komponenten, daß ein unzulässiger Zugriff auf die Speichereinrichtung M erfolgt ist. Anderenfalls, d.h. wenn es sich um einen zulässigen Zugriff handelt, veranlaßt die Steuereinrichtung CTRL durch Übermittlung der entsprechenden Steuersignale, Adressen und Daten an das Speichermodul MM, daß die der Speichereinrichtung M durch das "Load Page"-Kommando zugeführten und zwischengespeicherten Daten an die im "Write UC Page"-Kommando spezifizierte Page des zu beschreibenden UCB geschrieben werden.

Die Einträge in UCB0, UCB1, und UCB2 werden nur wirksam, wenn der jeweilige Confirmation Code in die UCBs geschrieben wurde. Durch ein Löschen oder Beschreiben der UCBs erfolgte Veränderungen des Inhalts der UCBs entfalten jedoch erst ab dem nächsten Rücksetzen des Mikrocontrollers Wirkung.

Der Confirmation Code sollte erst in den jeweiligen UCB geschrieben werden, wenn sicher ist, daß die darin gespeicherten Informationen richtig sind. Insbesondere sollte sicher sein, daß das im jeweiligen UCB gespeicherte Kennwort auch das Kennworte ist, das der Benutzer in den UCB schreiben wollte. Dies kann beispielsweise durch das später noch genauer beschriebene Kommando "Disable Write Protection" ermittelt werden. Die Übermittlung eines "Disable Write Protection"-Kommandos an die Speichereinrichtung M hat eine Fehlermeldung zur Folge, wenn das im Kommando enthaltene Kennwort nicht mit dem im UCB gespeicherten Kennworte übereinstimmt. Übermittelt der den UCB beschreibende Benutzer an die Speichereinrichtung M ein "Disable Write Protection"-Kommando, welches das soeben in den UCB geschriebene Kennwort als Kennwort enthält, so kann am Auftreten oder Ausbleiben dieser Fehlermeldung erkannt werden, ob das im UCB gespeicherte Kennwort das vom Benutzer festgelegte Kennwort ist oder nicht.

Der UCB0 und der UCB1 können durch den ersten Benutzer bzw. den zweiten Benutzer des Mikrocontrollers beliebig oft beschrieben und gelöscht werden. Es könnte auch vorgesehen werden, das Löschen und Wiederbeschreiben von UCB0 und UCB1 nur eine bestimmte Anzahl von Malen zuzulassen. Beispielsweise könnte vorgesehen werden, daß der UCB0 und der UCB1 maximal fünf mal beschreibbar sind.

Der erste Benutzer und der zweite Benutzer des Mikrocontrollers haben die Möglichkeit, die in UCB0 bzw. in UCB1 enthaltenen Einstellungen durch Übertragung entsprechender Kommandos, genauer gesagt durch Übertragung von diese Kommandos repräsentierenden Kommandosequenzen an die Speichereinrichtung M vorübergehend außer Kraft zu setzen. Dadurch kann durch den ersten Benutzer der von ihm in UCB0 eingestellte Lese- und Schreibschutz bzw. durch den zweiten Benutzer der von ihm in UCB1 eingestellte Schreibschutz temporär aufgehoben werden.

Die erwähnten Kommandos umfassen im betrachteten Beispiel ein Kommando "Disable Write Protection", ein Kommando "Disable Read Protection", und ein Kommando "Resume Protection".

Eine ein "Disable Write Protection"-Kommando repräsentierende Kommandosequenz kann beispielsweise darin bestehen, daß
- in einem ersten Zyklus bzw. in einem ersten Schreibzugriff auf die Speichereinrichtung die Adresse 5554 und die Daten AA,
- in einem zweiten Zyklus bzw. in einem zweiten Schreibzugriff auf die Speichereinrichtung die Adresse AAA8 und die Daten 55,
- in einem dritten Zyklus bzw. in einem dritten Schreibzugriff auf die Speichereinrichtung die Adresse 1111 und als Daten eine Kennung, die dem das Kommando veranlassenden Benutzer zugeordnet ist,
- in einem vierten Zyklus bzw. in einem vierten Schreibzugriff auf die Speichereinrichtung die Adresse 1112 und als Daten eine erste Hälfte des Kennwortes, das in dem UCB gespeichert ist, der dem im dritten Zyklus spezifizierten Benutzer zugeordnet ist,
- in einem fünften Zyklus bzw. in einem fünften Schreibzugriff auf die Speichereinrichtung die Adresse 1112 und als Daten die zweite Hälfte des Kennwortes, das in dem UCB gespeichert ist, der dem im dritten Zyklus spezifizierten Benutzer zugeordnet ist, und
- in einem sechsten Zyklus bzw. in einem sechsten Schreibzugriff auf die Speichereinrichtung die Adresse 3333 und die Daten 01,
an die Speichereinrichtung übertragen werden.

Wenn der Speichereinrichtung M eine des Kommando "Disable Write Protection" repräsentierende Kommandosequenz zugeführt wird, überprüft sie, genauer gesagt die Steuereinrichtung CTRL derselben, zunächst, ob die im dritten Zyklus übertragene Kennung die dem ersten Benutzer oder die dem zweiten Benutzer zugeordnete Kennung ist, und ob das im vierten Zyklus und im fünften Zyklus übertragene Kennwort das Kennwort ist, das in dem dem betreffenden Benutzer zugeordneten UCB gespeichert ist. Das Kennwort muß mit den in UCB0 gespeicherten Kennwort übereinstimmen, wenn die im dritten Zyklus übertragene Kennung die dem ersten Benutzer zugeordnete Kennung ist, bzw. muß mit dem in UCB1 gespeicherten Kennwort übereinstimmen, wenn die im dritten Zyklus übertragene Kennung die dem zweiten Benutzer zugeordnete Kennung ist. Wenn die Überprüfung ergibt, daß die genannten Bedingungen nicht erfüllt sind, geht die Steuereinrichtung CTRL davon aus, daß es sich bei dem ihr zugeführten Kommando um einen unzulässigen Zugriff (um einen Zugriff durch eine dazu nicht autorisierte Person) auf die Speichereinrichtung M handelt. In diesem Fall führt die Steuereinrichtung CTRL das Kommando nicht aus und signalisiert zudem der CPU und/oder sonstigen Mikrocontroller-Komponenten, daß ein unzulässiger Zugriff auf die Speichereinrichtung M erfolgt ist. Anderenfalls sorgt die Steuereinrichtung CTRL dafür, daß der Schreibschutz in dem Umfang, in welchen ihn der im dritten Zyklus der Kommandosequenz spezifizierte Benutzer in dem ihm zugeordneten UCB festgelegt hat, unwirksam wird.

In welchem Umfang der Schreibschutz unwirksam wird, hängt im betrachteten Beispiel zusätzlich davon ab, von welchem Benutzer das "Disable Write Protection"-Kommando stammt. Genauer gesagt ist es im betrachteten Beispiel so, daß die Einstellungen und Kommandos des ersten Benutzers Vorrang haben. D.h., durch ein vom zweiten Benutzer veranlaßtes "Disable Write Protection"-Kommando kann der Schreibschutz nur für diejenigen Sektoren aufgehoben werden, für die der erste Benutzer keinen Schreibschutz begehrt. D.h., wenn beispielsweise in UCB0 die Schreibschutzeinstellungs-Bits S0L und S1L gesetzt sind, und in UCB1 die Schreibschutzeinstellungs-Bits S0L und S2L, so wird durch ein vom zweiten Benutzer veranlaßtes "Disable Write Protection"-Kommando nur der Schreibschutz für den Sektor MMPS3 aufgehoben, nicht aber auch der Schreibschutz für den Sektor MMPS1, denn für diesen Sektor hat auch der erste Benutzer einen Schreibschutz eingestellt. Umgekehrt kann aber der erste Benutzer den Schreibschutz auch für solche Sektoren aufheben, für die der zweite Benutzer einen Schreibschutz eingestellt hat. D.h. wenn beispielsweise in UCB0 die Schreibschutzeinstellungs-Bits S0L und S1L gesetzt sind, und in UCB1 die Schreibschutzeinstellungs-Bits S0L und S2L, so wird durch ein vom ersten Benutzer veranlaßtes "Disable Write Protection"-Kommando der Schreibschutz für die Sektor MMPS1, MMPS2 und MMPS3 aufgehoben.

Es dürfte einleuchten, daß auch der umgekehrte Fall möglich ist, d.h. daß die Einstellungen und Kommandos des zweiten Benutzers Vorrang haben.

Ferner ist es auch möglich, daß der erste Benutzer und der zweite Benutzer gleichberechtigt sind, und kein Benutzer den Schreibschutz für Sektoren aufheben kann, für die der jeweils andere Benutzer einen Schreibschutz eingestellt hat.

Es wäre auch denkbar, eine Einstellmöglichkeit vorzusehen, durch welche einstellbar ist, welche Wirkung ein "Disable Write Protection"-Kommando der jeweiligen Benutzer hat. Beispielsweise könnte vorgesehen werden, daß die jeweiligen Benutzer einstellen können, ob und gegebenenfalls in welchem Umfang (für welche Sektoren) der jeweils andere Benutzer den Schreibschutz aufheben kann.

Unabhängig hiervon hat ein "Disable Write Protection"-Kommando auf keinen Fall zur Folge, daß der Schreibschutz für einen Sektor aufgehoben wird, der sich gemäß den Einstellungen in UCB2 wie ein ROM verhalten soll.

Eine ein "Disable Read Protection"-Kommando repräsentierende Kommandosequenz kann beispielsweise darin bestehen, daß
- in einem ersten Zyklus bzw. in einem ersten Schreibzugriff auf die Speichereinrichtung die Adresse 5554 und die Daten AA,
- in einem zweiten Zyklus bzw. in einem zweiten Schreibzugriff auf die Speichereinrichtung die Adresse AAA8 und die Daten 55,
- in einem dritten Zyklus bzw. in einem dritten Schreibzugriff auf die Speichereinrichtung die Adresse 1111 und die Daten 00,
- in einem vierten Zyklus bzw. in einem vierten Schreibzugriff auf die Speichereinrichtung die Adresse 1112 als Daten die erste Hälfte des Kennwortes, das in UCB0 gespeichert ist,
- in einem fünften Zyklus bzw. in einem fünften Schreibzugriff auf die Speichereinrichtung die Adresse 1112 als Daten die zweite Hälfte des Kennwortes, das in UCB0 gespeichert ist, und
- in einem sechsten Zyklus bzw. in einem sechsten Schreibzugriff auf die Speichereinrichtung die Adresse 3333 und die Daten 02,
an die Speichereinrichtung übertragen werden.

Wenn der Speichereinrichtung M eine das Kommando "Disable Read Protection" repräsentierende Kommandosequenz zugeführt wird, überprüft sie, genauer gesagt die Steuereinrichtung CTRL derselben zunächst, ob das im vierten und im fünften Zyklus übertragene Kennwort mit dem in UCB0 gespeicherten Kennwort übereinstimmt. Wenn die Überprüfung ergibt, daß diese Bedingungen nicht erfüllt ist, geht die Steuereinrichtung CTRL davon aus, daß es sich bei dem ihr zugeführten Kommando um einen unzulässigen Zugriff (um einen Zugriff durch eine dazu nicht autorisierte Person) auf die Speichereinrichtung M handelt. In diesem Fall führt die Steuereinrichtung CTRL das Kommando nicht aus und signalisiert zudem der CPU und/oder sonstigen Mikrocontroller-Komponenten, daß ein unzulässiger Zugriff auf die Speichereinrichtung M erfolgt ist. Anderenfalls sorgt die Steuereinrichtung CTRL dafür, daß kein Leseschutz mehr wirksam ist.

Eine ein "Resume Protection"-Kommando repräsentierende Kommandosequenz kann beispielsweise darin bestehen, daß in einem einzigen Zyklus bzw. in einem einzigen Schreibzugriff auf die Speichereinrichtung die Adresse 5554 und die Daten BB an die Speichereinrichtung M übertragen werden.

Wenn der Speichereinrichtung M eine des Kommando "Resume Protection" repräsentierende Kommandosequenz zugeführt wird, werden der Leseschutz und der Schreibschutz in dem Umfang, in welchem er durch die Lese- und Schreibschutzeinstellungs-Bits des UCB0 und des UCB1 festgelegt ist, wieder wirksam.

Die Kommandos "Disable Read Protection", "Disable Write Protection", und "Resume Protection" entfalten jeweils sofort, also nicht etwa erst nach dem nächsten Rücksetzen des Mikrocontrollers oder einem sonstigen späteren Zeitpunkt Wirkung.

Ob und gegebenenfalls in welchem Umfang ein Leseschutz und/oder ein Schreibschutz wirksam ist, hängt auch noch vom Inhalt eines Speicher-Konfigurationsregisters ab. Dieses Speicher-Konfigurationsregister ist im betrachteten Beispiel Bestandteil der Steuereinrichtung CTRL der Speichereinrichtung M. Der Aufbau des Speicher-Konfigurationsregisters ist in Figur 5 veranschaulicht.

Wie aus der Figur 5 ersichtlich ist, handelt es sich beim Speicher-Konfigurationsregister um ein 32-Bit-Register, von welchem vorliegend jedoch nur die Bits 0 bis 5 interessieren.

Bit 0 ist mit dem Bezugszeichen RPA bezeichnet, Bit 1 mit dem Bezugszeichen DCF, Bit 2 mit dem Bezugszeichen DDF, Bit 3 mit dem Bezugszeichen DDFDBG, Bit 4 mit dem Bezugszeichen DDFDMA, und Bit 5 mit dem Bezugszeichen DDFPCP.

Durch das Bit RPA wird angegeben, ob ein Leseschutz wirksam sein soll. Ein Leseschutz ist wirksam und das Bit RPA ist gesetzt, wenn das Bit RPRO in UCB0 gesetzt ist, und der Leseschutz nicht durch durch das Kommando "Disable Read Protection" temporär aufgehoben ist.

Durch die Bits DCF und DDF wird festgelegt, welche Art von Lesezugriffen auf das Speichermodul MM zulässig sein sollen, und durch die Bits DDFDBG, DDFDMA, und DDFPCP und/oder weitere oder andere Steuerbits wird festgelegt, welche Mikrocontroller-Komponenten, die auf die Speichereinrichtung M zugreifen können, zulässige Lesezugriffe auf die Speichereinrichtung M ausführen können. Die Bits DCF und DDF werden allerdings nur ausgewertet, wenn Bit RPA gesetzt ist. Genauer gesagt ist es so,
- daß es von den Werten der Bits RPA (Read Protection Active) und DCF (Disable Code Fetch) abhängt, ob Code Fetches, also Lesezugriffe der CPU des Mikrocontrollers auf von der CPU als Befehlscode verwendete Daten zulässig sind; wenn das Bit RPA gesetzt ist und das Bit DCF den Wert 0 hat, sind Code Fetches zulässig, anderenfalls nicht.
- daß es von den Werten der Bits RPA (Read Protection Active) und DDF (Disable Data Fetch) abhängt, ob Data Fetches, also Lesezugriffe der CPU des Mikrocontrollers auf nicht als Befehlscode verwendete Daten zulässig sind; wenn das Bit RPA gesetzt ist und das Bit DDF den Wert 0 hat, sind Data Fetches zulässig, anderenfalls nicht.
- daß es vom Wert des Bits DDFDBG (Disable Data Fetch from Debug Controller) abhängt, ob ein im Mikrocontroller enthaltener Debug Controller, also beispielsweise das eingangs bereits erwähnte OCDS-Modul, Lesezugriffe auf das Speichermodul MM (den Programmspeicher MMP und den Datenspeicher MMD) ausführen darf; wenn das Bit DDFDBG den Wert 0 hat, sind Lesezugriffe durch den Debug Controller auf das Speichermodul MM zulässig, anderenfalls nicht.
- daß es vom Wert des Bits DDFDMA (Disable Data Fetch from DMA Controller) abhängt, ob ein im Mikrocontroller enthaltener DMA-Controller Lesezugriffe auf das Speichermodul MM (den Programmspeicher MMP und den Datenspeicher MMD) ausführen darf; wenn das Bit DDFDBG den Wert 0 hat, sind Lesezugriffe durch den DMA-Controller auf das Speichermodul MM zulässig, anderenfalls nicht.
- daß es vom Wert des Bit DDFPCP (Disable Data Fetch from PCP) abhängt, ob ein im Mikrocontroller enthaltener PCP (Peripheral Control Processor) Lesezugriffe auf das Speichermodul MM (den Programmspeicher MMP und den Datenspeicher MMD) ausführen darf; wenn das Bit DDFDBG den Wert 0 hat, sind Lesezugriffe durch den DMA-Controller auf das Speichermodul MM zulässig, anderenfalls nicht.

Es können selbstverständlich auch noch weitere Konfigurations-Bits vorgesehen sein, von deren Wert es jeweils abhängt, ob eine bestimmte weitere Komponente des Mikrocontrollers oder des den Mikrocontroller enthaltenden Systems Lesezugriffe auf das Speichermodul MM (den Programmspeicher MMP und den Datenspeicher MMD) ausführen darf. Beispielsweise können weitere Konfigurations-Bits vorgesehen sein, von deren Wert es abhängt, ob weitere Prozessoren des Mikrocontrollers, oder außerhalb des Mikrocontrollers vorgesehene Prozessoren Lesezugriffe auf das Speichermodul MM durchführen dürfen.

Welche Mikrocontroller-Komponente auf das Speichermodul MM zugreift, und ob es sich bei dem Zugriff um einen Code Fetch oder um einen Data Fetch handelt, kann anhand eines Identifiers ermittelt werden, den die auf das Speichermodul MM zugreifende Mikrocontroller-Komponente bei einem Zugriff auf das Speichermodul MM zusammen mit der Leseanforderung bzw. der Schreibanforderung an das Speichermodul MM oder die Speichereinrichtung M übermittelt.

Das Speicher-Konfigurationsregister kann sowohl durch die Hardware, insbesondere durch die Steuereinrichtung CTRL oder eine sonstige Mikrocontroller-Komponente, als auch durch den Benutzer des Mikrocontrollers ausgelesen und beschrieben werden.

Das Beschreiben des Speicher-Konfigurationsregisters durch den Benutzer des Mikrocontrollers erfolgt im betrachteten Beispiel durch die Übermittlung eines Kommandos "Write Register" an die Speichereinrichtung M, genauer gesagt durch die Zuführung einer dieses Kommando repräsentierenden Kommandosequenzen. Es sei jedoch bereits an dieser Stelle darauf hingewiesen, daß das Beschreiben des Speicher-Konfigurationsregisters auch auf andere Art und Weise, beispielsweise durch einen einfachen Registerzugriff erfolgen könnte.

Durch das Kommando "Write Register" kann der Benutzer jedoch nur bestimmte Bits des Speicher-Konfigurationsregisters verändern, wobei selbst dies teilweise auch noch an bestimmte Bedingungen geknüpft ist. Insbesondere ist es nicht möglich, daß der Benutzer durch das Kommando "Write Register" das Bit RPA verändert. Das Beschreiben dieses Bits kann nur durch die Steuereinrichtung CTRL erfolgen. Ferner ist es nicht möglich, durch das Kommando "Write Register" die Fetch Control Bits DCF und DDF zu verändern, wenn das Bit RPA gesetzt ist; vor einer Veränderung der Bits DCF und DDF muß gegebenenfalls erst durch das Kommando "Disable Read Protection" der Leseschutz aufgehoben werden. Es könnte sich jedoch unter Umständen als vorteilhaft erweisen, wenn nur vor dem Rücksetzen der Bits DCF, DDF eine Aufhebung des Leseschutzes erfolgen muß, und ein Setzen dieser Bits ohne eine Aufhebung des Leseschutzes durchgeführt werden kann. Im folgenden wird jedoch davon ausgegangen, daß sowohl beim Setzen als auch beim Zurücksetzen der genannten Bits kein Leseschutz wirksam sein darf.

Eine ein "Write Register"-Kommando repräsentierende Kommandosequenz kann beispielsweise darin bestehen, daß
- in einem ersten Zyklus bzw. in einem ersten Schreibzugriff auf die Speichereinrichtung die Adresse 5554 und die Daten CC, und
- in einem zweiten Zyklus bzw. in einem zweiten Schreibzugriff auf die Speichereinrichtung als Adresse die Adresse des zu beschreibenden Registers, und als Daten die in dieses Register zu schreibenden Daten
an die Speichereinrichtung übertragen werden.

Wenn der Speichereinrichtung M eine des Kommando "Write Register" repräsentierende Kommandosequenz zugeführt wird, überprüft sie, genauer gesagt die Steuereinrichtung CTRL derselben zunächst, ob es sich hierbei um einen zulässigen Zugriff auf die Speichereinrichtung M handelt. Ein unzulässiger Zugriff liegt beispielsweise vor, wenn ein Leseschutz wirksam ist und das Bit DCF und/oder das Bit DDF verändert werden soll. Wenn die Steuereinrichtung CTRL feststellt, daß es sich um einen unzulässigen Zugriff auf die Speichereinrichtung M handelt, führt sie diesen Zugriff nicht aus und signalisiert zudem der CPU und/oder sonstigen Mikrocontroller-Komponenten, daß ein unzulässiger Zugriff auf die Speichereinrichtung M erfolgt ist. Anderenfalls, d.h. wenn es sich um einen zulässigen Zugriff handelt, veranlaßt die Steuereinrichtung CTRL, daß die im zweiten Zyklus der Kommandosequenz übertragenen Daten in das im zweiten Zyklus der Kommandosequenz spezifizierte Register geschrieben werden.

Der Vollständigkeit halber sei angemerkt, daß die Speichereinrichtung M neben dem Speicher-Konfigurationsregister auch noch ein Flash Status Register enthält, in welchem der aktuelle Status des Speichermoduls MM sowie und eventuelle unzulässige Zugriffe auf die Speichereinrichtung M angezeigt werden. Dieses Register kann durch den Benutzer nicht überschrieben werden. Die darin enthaltenen Status- und Fehleranzeigen lassen sich jedoch mit dem Kommando "Clear Status" zurücksetzen

Eine ein "Clear Status"-Kommando repräsentierende Kommandosequenz kann beispielsweise darin bestehen, daß in einem Schreibzugriff auf die Speichereinrichtung die Adresse 5554 und die Daten DD an die Speichereinrichtung übertragen werden.

Der Vollständigkeit halber sei angemerkt, daß auch noch ein Kommando "Read Register" existiert, durch welches die Inhalte bestimmter Register der Speichereinrichtung M ausgelesen werden können. Zu den durch das Kommando "Read Register" auslesbaren Registern gehören auch das Speicher-Konfigurationsregister und das Flash Status Register.

Veränderungen der Bits DCF, DDF, DDFDBG, DDFDMA, und DDFPCP entfalten jeweils sofort, also nicht etwa erst nach dem nächsten Rücksetzen des Mikrocontrollers oder einem sonstigen späteren Zeitpunkt Wirkung.

Wie vorstehend beschrieben wurde, hat der Benutzer des Mikrocontrollers eine ganze Reihe von Möglichkeiten, den Leseschutz und den Schreibschutz entsprechend seinen Wünschen zu konfigurieren. Wann und in welchem Umfang der Leseschutz und der Schreibschutz wirksam sind, wird aber auch durch die Speichereinrichtung M, genauer gesagt durch die Steuereinrichtung CTRL derselben mitbestimmt. Dies wird im folgenden näher erläutert.

Unmittelbar nach dem Einschalten oder Zurücksetzen des Mikrocontrollers überprüft die Steuereinrichtung CTRL oder eine sonstige Mikrocontroller-Komponente, ob ein Leseschutz wirksam sein soll. Dies ist der Fall, wenn das Leseschutzeinstellungs-Bit RPRO des UCB0 gesetzt ist und in den UCB0 ein gültiger Confirmation Code geschrieben wurde.

Wenn ein Leseschutz wirksam sein soll, überprüft die Steuereinrichtung CTRL oder eine sonstige Mikrocontroller-Komponente, wie sich der Mikrocontroller nach dem Einschalten oder Zurücksetzen verhalten soll. Beim betrachteten Mikrocontroller existieren hierfür drei Möglichkeiten, nämlich
1) daß der Mikrocontroller nach der Inbetriebnahme bzw. dem Rücksetzen ein außerhalb der Speichereinrichtung M, also ein in einem ungeschützten internen oder externen Speicher gespeichertes Programm ausführen soll,
2) daß der Mikrocontroller nach der Inbetriebnahme bzw. dem Rücksetzen einen dem Mikrocontroller von außen zugeführten Bootstrap-Loader ausführen soll, und
3) daß der Mikrocontroller nach der Inbetriebnahme bzw. dem Rücksetzen ein innerhalb der Speichereinrichtung M gespeichertes Programm ausführen soll.

Wie sich der Mikrocontroller nach der Inbetriebnahme bzw. dem Rücksetzen verhalten soll, wird ihm im betrachteten Beispiel durch Signale vorgegeben, die während des Einschaltens oder des Zurücksetzens des Mikrocontrollers an bestimmte Ein- und/oder Ausgabeanschlüsse des Mikrocontrollers angelegt werden. Unter Auswertung dieser Signale stellt der Mikrocontroller fest, wie er sich nach dem Einschalten bzw. nach dem Zurücksetzen zu verhalten hat.

Wenn sich hierbei ergibt, daß der Mikrocontroller nach der Inbetriebnahme bzw. dem Rücksetzen ein außerhalb der Speichereinrichtung M gespeichertes Programm ausführen soll, sorgt die Steuereinrichtung CTRL oder eine andere Mikrocontroller-Komponente dafür, daß die Bits DCF und DDF des Speicher-Konfigurationsregisters gesetzt werden, wodurch, wenn gleichzeitig ein Leseschutz gewünscht wird, also das Bit RPA gesetzt ist, weder Lesezugriffe auf den Programmspeicher MMP noch Lesezugriffe auf den Datenspeicher MMD zugelassen werden. Falls der Entwickler des außerhalb der Speichereinrichtung M gespeicherten Programmes nicht eine zum Auslesen der Speichereinrichtung M autorisierte Person ist, kann diese den Leseschutz nicht aufheben, denn hierzu müßte sie das in UCB0 gespeicherte Kennwort kennen, was aber im allgemeinen nicht der Fall sein dürfte.

Wenn der Mikrocontroller nach der Inbetriebnahme bzw. dem Rücksetzen einen dem Mikrocontroller von außen (z.B. über ein serielles Interface des Mikrocontrollers) zugeführten Bootstrap-Loader ausführen soll, sorgt die Steuereinrichtung CTRL oder eine andere Mikrocontroller-Komponente dafür, daß die Bits DCF und DDF gesetzt werden und somit ein Leseschutz wirksam ist, während das zugeführte Programm ausgeführt wird.

Wenn der Mikrocontroller nach der Inbetriebnahme bzw. dem Rücksetzen ein innerhalb der Speichereinrichtung M gespeichertes Programm ausführen soll, wird dies zugelassen und darüber hinaus durch die Steuereinrichtung CTRL oder eine andere Mikrocontroller-Komponente dafür gesorgt, daß die Bits DCF und DDF des Speicher-Konfigurationsregisters zurückgesetzt werden, wodurch sowohl Lesezugriffe auf den Programmspeicher MMP als auch Lesezugriffe auf den Datenspeicher MMD zugelassen werden.

Wie aus den vorstehenden Erläuterungen ersichtlich ist, wird nur im Fall, daß der Mikrocontroller nach der Inbetriebnahme bzw. dem Rücksetzen ein außerhalb der Speichereinrichtung M gespeichertes Programm ausführt, durch Setzen der Bits DCF und DDF dafür gesorgt, daß ein Leseschutz wirksam ist. Wenn der Mikrocontroller nach der Inbetriebnahme bzw. dem Rücksetzen ein innerhalb der Speichereinrichtung M gespeichertes Programm ausführt, ist dies nicht erforderlich, denn in diesem Fall kann der Entwickler des in der Speichereinrichtung M gespeicherten Programmes selbst dafür sorgen, daß keine Lesezugriffe durch hierzu nicht autorisierte Personen auf die Speichereinrichtung M erfolgen: er kann das in der Speichereinrichtung M gespeicherte Programm so schreiben, daß keine Sprünge in ungeschützte Speicher oder Speicherbereiche erfolgen bzw. daß dann, wenn ein Sprung in einen ungeschützten Speicher oder Speicherbereich erfolgt, kein Zugriff mehr oder nur noch bestimmte Zugriffe auf die Speichereinrichtung M erfolgen können. Letzteres kann dadurch geschehen, daß das in der Speichereinrichtung M gespeicherte Programm Befehle enthält, die dafür sorgen, daß vor der Ausführung eines Sprunges in einen ungeschützten Speicher oder Speicherbereich die Bits DCF und/oder DDF des Speicher-Konfigurationsregisters gesetzt werden. Der Vollständigkeit halber sei angemerkt, daß bei nicht gesetztem Bit DCF wieder ein Rücksprung in die Speichereinrichtung M möglich ist, wohingegen bei gesetztem Bit DCF nicht einmal dies mehr möglich ist. Damit ein Rücksprung in die Speichereinrichtung M erfolgen kann, müßte zunächst durch das Kommando "Disable Read Protection" der Leseschutz aufgehoben werden.

Dadurch kann - teils automatisch durch den Mikrocontroller, und teils durch ein entsprechend geschriebenes Programm - zuverlässig verhindert werden, daß der Inhalt der Speichereinrichtung M durch nicht in der Speichereinrichtung M gespeicherte Befehle ausgelesen wird. Da bei entsprechender Konfiguration des Lese-/Schreibschutzes aber nur bestimmte Personen in der Lage sind, die Speichereinrichtung M zu beschreiben, haben nicht autorisierte Personen keine Chance, den Inhalt der Speichereinrichtung M auszulesen oder zu verändern.

Wenn das Leseschutzeinstellungs-Bit RPRO des UCB0 gesetzt ist und in den UCB0 ein gültiger Confirmation Code geschrieben wurde, wird durch die Steuereinrichtung CTRL oder eine sonstige Mikrocontroller-Komponente vorzugsweise auch sofort das Bit DDFDBG des Speicher-Konfigurationsregisters, und gegebenenfalls auch die Bits DDFDMA und/oder DDFPCP des Speicher-Konfigurationsregisters gesetzt. Die genannten Bits können aber auch durch entsprechende Befehle im ausgeführten Programm gesetzt und zurückgesetzt werden. Durch diese Maßnahme können nicht autorisierte Personen auch nicht über den Debug-Controller und/oder den DMA-Controller und/oder den Peripheral Control Prozessor auf die Speichereinrichtung M zugreifen.

Vorzugsweise ist bei wirksamem Leseschutz automatisch auch ein Schreibschutz wirksam, und zwar für die gesamte Speichereinrichtung M. Dadurch kann verhindert werden, daß durch eine hierzu nicht autorisierte Person eine Leseroutine (beispielsweise ein Trojanisches Pferd) in die Speichereinrichtung M geschrieben wird, welche dann den gesamten Speicherinhalt auslesen und aus dem Mikrocontroller ausgeben könnte.

Der Mikrocontroller sorgt darüber hinaus dafür, daß nach der Inbetriebnahme oder dem Rücksetzen des Mikrocontrollers in dem Umfang, wie er in den UCBs festgelegt ist, ein selektiver, d.h. vom Leseschutz unabhängiger Schreibschutz wirksam ist.

Dieser selektive Schreibschutz kann durch den Benutzer mittels der Kommandos "Disable Write Protection" und "Resume Protection", genauer gesagt durch Programmbefehle, durch welche die Übermittlung dieser Kommandos an die Speichereinrichtung M veranlaßt wird, temporär ganz oder teilweise aufgehoben werden.

Der mit dem Leseschutz gekoppelte Schreibschutz kann durch das Kommando "Disable Read Protection"temporär aufgehoben werden.

Wie vorstehend bereits mehrfach erwähnt wurde, signalisiert die Steuereinrichtung CTRL der CPU und/oder einer sonstigen Mikrocontroller-Komponente eine Speicherschutzverletzung, wenn ein unzulässiger Zugriff auf die Speichereinrichtung M erfolgt. Dies kann beispielsweise durch einen entsprechenden Eintrag in ein Statusregister, beispielsweise in das vorstehend bereits erwähnte Flash Status Register, und/oder durch einen Interrupt Request erfolgen. Wie die CPU hierauf reagiert, hängt vorzugsweise vom Einsatz des Mikrocontrollers ab. Die Reaktionen können beispielsweise, aber verständlicherweise nicht ausschließlich darin bestehen,
- daß dafür gesorgt wird, daß die Programmausführung beendet wird und bis zur nächsten Inbetriebnahme oder bis zum nächsten Zurücksetzen des Mikrocontrollers keine weiteren Befehle mehr ausgeführt, oder
- daß dafür gesorgt wird, daß der unzulässige Zugriff mit korrekten Parametern wiederholt werden kann, oder
- daß dafür gesorgt wird, daß bis zur nächsten Inbetriebnahme oder oder bis zum nächsten Zurücksetzen des Mikrocontrollers nur noch bestimmte Zugriffe auf die Speichereinrichtung M zugelassen werden, beispielsweise nur solche Zugriffe, welche keinen Einfluß auf den Umfang des Leseschutzes und/oder des Schreibschutzes haben oder die Voraussetzung für solche Zugriffe sind (also kein "Disable Read Protection"-Kommando, und/oder kein "Disable Write Protection"-Kommando, und/oder kein "Erase UCB"-Kommando, und/oder kein "Write UC Page"-Kommando mehr ausgeführt wird).

Vorzugsweise ist es so, daß nach einem Versuch, den Leseschutz oder den Schreibschutz betreffende Einstellungen oder Konfigurationen unter Verwendung eines falschen Kennwortes zu verändern, ein weiterer Versuch zur Veränderung der Einstellungen oder Konfigurationen erst nach dem Zurücksetzen oder einer erneuten Inbetriebnahme der programmgesteuerten Einheit möglich ist. Zumindest nach einem Versuch, den Leseschutz oder den Schreibschutz unter Verwendung eines falschen Kennwortes temporär aufzuheben, sollte ein weiterer Versuch zur temporären Aufhebung des Leseschutzes oder des Schreibschutzes erst nach dem Zurücksetzen oder einer erneuten Inbetriebnahme der programmgesteuerten Einheit möglich sein.

Selbstverständlich kann der Mikrocontroller auf einen unzulässigen Zugriff auf die Speichereinrichtung M auch beliebig anders reagieren. Die Reaktion des Mikrocontrollers kann auch von der Art des unzulässigen Zugriffes abhängig gemacht werden. Beispielsweise kann vorgesehen werden, daß der gescheiterte Versuch, den Leseschutz temporär aufzugeben (Disable Read Protection), durch härtere bzw. umfangreichere Maßnahmen sanktioniert wird als ein unzulässiger Lesezugriff auf den Datenspeicher MMD.

Wie vorstehend erläutert wurde, kann der UCB0 durch einen ersten Benutzer des Mikrocontrollers beschrieben und gelöscht werden, der UCB1 durch einen zweiten Benutzer des Mikrocontrollers beschrieben und gelöscht werden, und der UCB2 durch einen dritten Benutzer beschrieben werden. Dies erweist sich als vorteilhaft, weil dadurch im betrachteten Beispiel bis zu drei Benutzer ihre Daten weitestgehend unabhängig voneinander vor Zugriffen durch dazu nicht autorisierte Personen schützen können.

Wenn der beschriebene Mikrocontroller Bestandteil eines Kraftfahrzeugsteuergerätes ist, und durch den Mikrocontroller ein Programm ausgeführt wird, dessen Befehle und/oder Operanden teilweise vom Hersteller des Kraftfahrzeugsteuergerätes stammen, und teilweise vom Hersteller des Kraftfahrzeuges, so können sowohl der Hersteller des Kraftfahrzeugsteuergerätes als auch der Hersteller des Kraftfahrzeuges ihre Programmteile und/oder Operanden vor einem Auslesen und/oder vor Veränderungen durch dazu nicht autorisierte Personen schützen: der Hersteller des Kraftfahrzeugsteuergerätes kann der erste Benutzer des Mikrocontrollers sein und den Schutz seiner Programmteile und/oder Operanden durch entsprechendes Beschreiben des UCB0 konfigurieren, und der Hersteller des Kraftfahrzeuges kann der zweite Benutzer des Mikrocontrollers sein und den Schutz seiner Programmteile und/oder Operanden durch entsprechendes Beschreiben des UCB1 konfigurieren; darüber hinaus kann entweder der Hersteller des Kraftfahrzeugsteuergerätes oder der Hersteller des Kraftfahrzeuges der dritte Benutzer sein und den Schutz seiner Programmteile und/oder Operanden zusätzlich durch entsprechendes Beschreiben des UCB2 konfigurieren. Selbstverständlich kann der dritte Benutzer auch eine dritte Person oder ein drittes Unternehmen sein, das an, der Entwicklung des in der Speichereinrichtung M gespeicherten Programmes beteiligt ist. Ebenso ist es natürlich auch möglich, daß eine einzige Person oder ein einziges Unternehmen sowohl der erste Benutzer als auch der zweite Benutzer ist.

Durch Vorsehen weiterer UCBs können auch noch weitere Benutzer des Mikrocontrollers ihre Daten vor Zugriffen durch hierzu nicht autorisierte Personen schützen.

Der Vollständigkeit halber sei angemerkt, daß die Übertragung der vorstehend beschriebenen Kommandosequenzen zur Speichereinrichtung M, auch die Übertragung der Kommandosequenzen zur Konfigurierung des Leseschutzes und/oder des Schreibschutzes durch entsprechende Befehle in dem von der CPU ausgeführten Programm veranlaßt wird.

Die Speichereinrichtung M kann nach alledem auf sehr einfache Art und Weise zuverlässig vor Zugriffen durch hierzu nicht autorisierte Personen geschützt werden. Darüber hinaus können der Umfang des Leseschutzes und der Umfang des Schreibschutzes unabhängig voneinander optimal an die jeweiligen Verhältnisse angepaßt werden.

### Bezugszeichenliste

| | |
|---|---|
| ADDRBUSx | Adreßbus |
| BUS | Bus |
| CPU | CPU |
| CTRL | Steuereinrichtung |
| CTRLBUSx | Steuerbus |
| DCF | Konfigurations-Bit |
| DDF | Konfigurations-Bit |
| DDFDBG | Konfigurations-Bit |
| DDFDMA | Konfigurations-Bit |
| DDFPCP | Konfigurations-Bit |
| ECCBUSx | Fehlerkorrekturdatenbus |
| ECU | Fehlerkorrektureinrichtung |
| M | Speichereinrichtung |
| MI | Schnittstelle |
| MM | Speichermodul |
| MMD | Datenspeicher |
| MMDSx | Datenspeicher-Sektor |
| MMP | Programmspeicher |
| MMPSx | Programmspeicher-Sektor |
| Px | Peripherieeinheit |
| PG | Programmgesteuerte Einheit |
| RDATABUSx | Lesedatenbus |
| RPA | Konfigurations-Bit |
| RPRO | Leseschutzeinstellungs-Bit |
| SxL | Schreibschutzeinstellung-Bit |
| SxROM | Schreibschutzeinstellung-Bit |
| WDATABUSx | Schreibdatenbus |

## Patentansprüche

1. Programmgesteuerte Einheit mit einem wiederholt umprogrammierbaren nichtflüchtigen Speicher (MMPS1 - MMPS13) zum Speichern von Daten,
- wobei die programmgesteuerte Einheit eine Speicherschutzvorrichtung (MI) enthält, und sämtliche Zugriffe auf den Speicher (MMPS1 - MMPS13) über diese Speicherschutzvorrichtung (MI) erfolgen, und wobei die Speicherschutzvorrichtung (MI) vor der Durchführung eines Lösch- oder Schreibzugriffes auf den Speicher (MMPS1 - MMPS13) überprüft, ob für den durch den Zugriff zu löschenden oder zu beschreibenden Teil des Speichers (MMPS1 - MMPS13) ein Schreibschutz wirksam ist, und somit in der Lage ist, dafür zu sorgen, daß der Inhalt des Speichers (MMPS1 - MMPS13) oder eines bestimmten Teils desselben nie mehr verändert werden kann,
- wobei der Benutzer der programmgesteuerten Einheit einstellen kann, ob und gegebenenfalls welche Teile des Speichers (MMPS1 - MMPS13) nie mehr verändert werden können sollen,
- wobei die Einstellungen des Benutzers in einem nichtflüchtigen Speicher (MMPS0) der programmgesteuerten Einheit gespeichert werden, auf welchen ebenfalls über die Speicherschutzvorrichtung (MI) zugegriffen wird,
- wobei der Inhalt des die Einstellungen des Benutzers speichernden Speichers (MMPS0) nach dem Einschreiben eines Confirmation Codes in diesen Speicher (MMPS0) nicht mehr veränderbar ist, und
- wobei durch den Inhalt des die Benutzereinstellungen enthaltenden Speichers (MMPS0) festgelgt wird, ob der Inhalt des Speichers (MMPS1 - MMPS13) oder eines bestimmten Teils desselben verändert werden kann.

2. Programmgesteuerte Einheit nach Anspruch 1,
**dadurch gekennzeichnet,**
**daß** der Speicher (MMPS1 - MMPS13) ein Flash-Speicher ist.

3. Programmgesteuerte Einheit nach einem der vorhergehenden Ansprüche,
**dadurch gekennzeichnet,**
**daß** der die Benutzereinstellungen enthaltende Speicher (MMPS0) durch den Benutzer der programmgesteuerten Einheit nicht auslesbar ist.

4. Programmgesteuerte Einheit nach einem der vorhergehenden Ansprüche,
**dadurch gekennzeichnet,**
**daß** die Einstellungen des Benutzers erst gültig sind, nachdem der Benutzer den Einstellvorgang durch die Eingabe des Confirmation Codes abgeschlossen hat.

5. Programmgesteuerte Einheit nach einem der vorhergehenden Ansprüche,
**dadurch gekennzeichnet,**
**daß** der die Einstellungen des Benutzers speichernde Speicher (MMPS0) ein wiederholt umprogrammierbarer Speicher ist.

6. Programmgesteuerte Einheit nach einem der vorhergehenden Ansprüche,
**dadurch gekennzeichnet,**
**daß** die Einstellungen des Benutzers erst nach dem dem Einstellvorgang folgenden Rücksetzen der programmgesteuerten Einheit wirksam werden.

## Claims

1. Program-controlled unit comprising a repeatedly reprogrammable nonvolatile memory (MMPS1 MMPS13) for storing data,
- wherein the program-controlled unit contains a memory protection apparatus (MI) and all accesses to the memory (MMPS1 - MMPS13) are effected via said memory protection apparatus (MI), and wherein the memory protection apparatus (MI), before an erase or write access to the memory (MMPS1 - MMPS13) is carried out, checks whether write protection is effective for that part of the memory (MMPS1 - MMPS13) which is to be erased or written to by the access and therefore is able to ensure that the content of the memory (MMPS1 - MMPS13) or of a specific part thereof can never again be altered,
- wherein the user of the program-controlled unit can set whether and, if appropriate, what parts of the memory (MMPS1
- MMPS13) are intended to never again be able to be altered,
- wherein the user's settings are stored in a nonvolatile memory (MMPSO) of the program-controlled unit, which nonvolatile memory is likewise accessed via the memory protection apparatus (MI),
- wherein the content of the memory (MMPSO) that stores the user's settings can no longer be altered after a confirmation code is written to said memory (MMPSO),
- wherein the content of the memory (MMPSO) containing the user settings defines whether the content of the memory (MMPS1 - MMPS13) or of a specific part thereof can be altered.

2. Program-controlled unit according to Claim 1, **characterized in that** the memory (MMPS1 MMPS13) is a flash memory.

3. Program-controlled unit according to either of the preceding claims, **characterized in that** the memory (MMPSO) containing the user settings cannot be read from by the user of the program-controlled unit.

4. Program-controlled unit according to any of the preceding claims, **characterized in that** the user's settings do not become valid until after the user has concluded the setting operation by inputting the confirmation code.

5. Program-controlled unit according to any of the preceding claims, **characterized in that** the memory (MMPSO) that stores the user's settings is a repeatedly reprogrammable memory.

6. Program-controlled unit according to any of the preceding claims, **characterized in that** the user's settings do not become effective until after the resetting of the program-controlled unit that follows the setting operation.

## Revendications

1. Unité commandée par programme comprenant une mémoire non volatile reprogrammable de manière répétée (MMPS1
- MMPS13) pour stocker des données,
- dans laquelle l'unité commandée par programme comporte un dispositif de protection de la mémoire (MI), et tous les accès à la mémoire (MMPS1 - MMPS13) s'effectuent par l'intermédiaire de ce dispositif de protection de la mémoire (MI), et dans laquelle le dispositif de protection de la mémoire (MI) vérifie, avant d'effectuer un accès d'effacement ou d'écriture à la mémoire (MMPS1 - MMPS13), si, pour la partie à effacer ou à écrire de la mémoire (MMPS1 - MMPS13) du fait de cet accès, une protection contre l'écriture est active, et est donc en mesure de faire en sorte que le contenu de la mémoire (MMPS1 - MMPS13) ou d'une partie donnée de celle-ci ne puisse plus jamais être modifiée,
- dans laquelle l'utilisateur de l'unité commandée par programme peut effectuer un réglage pour déterminer si des parties, et le cas échéant quelles parties de la mémoire (MMPS1 - MMPS13) ne devront plus jamais pouvoir être modifiées,
- dans laquelle les réglages de l'utilisateur sont stockés dans une mémoire non volatile (MMPSO) de l'unité commandée par programme, à laquelle un accès peut le cas échéant être effectué par l'intermédiaire du dispositif de protection de la mémoire (MI),
- dans laquelle le contenu de la mémoire (MMPSO) non volatile stockant les réglages de l'utilisateur ne peut plus être modifié après l'écriture d'un code de confirmation dans cette mémoire (MMPSO), et
- dans laquelle il est établi par l'intermédiaire du contenu de la mémoire (MMPSO) contenant les réglages de l'utilisateur, si le contenu de la mémoire (MMPS1 - MMPS13) ou d'une partie donnée de celle-ci peut être modifié.

2. Unité commandée par programme selon la revendication 1, **caractérisée en ce que** la mémoire (MMPS1 - MMPS13) est une mémoire flash.

3. Unité commandée par programme selon l'une quelconque des revendications précédentes, **caractérisée en ce que** la mémoire (MMPSO) contenant les réglages de l'utilisateur ne peut pas être lue par l'utilisateur de l'unité commandée par programme.

4. Unité commandée par programme selon l'une quelconque des revendications précédentes, **caractérisée en ce que** les réglages de l'utilisateur ne sont valides qu'après que l'utilisateur a achevé le processus de réglage en saisissant le code de confirmation.

5. Unité commandée par programme selon l'une quelconque des revendications précédentes, **caractérisée en ce que** la mémoire (MMPSO) stockant les réglages de l'utilisateur est une mémoire reprogrammable de manière répétée.

6. Unité commandée par programme selon l'une quelconque des revendications précédentes, **caractérisée en ce que** les réglages de l'utilisateur ne prennent effet qu'après la réinitialisation consécutive au processus de réglage de l'unité commandée par programme.
